# NEW EUROPEAN PATENT SPECIFICATION

(11) **EP 2 141 747 B2**
(45) Date of publication and mention of the opposition decision: **16.11.2022**
(45) Mention of the grant of the patent: 17.10.2018
(21) Application number: 09251721.8
(22) Date of filing: 03.07.2009
(51) Int. Cl.: H01L 31/048, H01L 31/05, H01L 31/054

(54) **Solar cell module**
Solarzellenmodul
Module de cellule solaire

(30) Priority: 04.07.2008 JP 2008175972
(43) Date of publication of application: 06.01.2010
(73) Proprietor: Panasonic Intellectual Property Management Co., Ltd., Osaka-shi, Osaka 540-6207 (JP)
(72) Inventor: Haga, Takahiro, Mariguchi City, Osaka 570-8677 (JP); Okamoto, Shingo, Mariguchi City, Osaka 570-8677 (JP)
(74) Representative: Mewburn Ellis LLP

(56) References cited:
- EP-A1- 1 172 864
- EP-A2- 1 852 917
- WO-A1-99/09601
- WO-A1-99/56317
- DE-A1-102004 046 554
- DE-A1-102006 021 804
- DE-A1-102008 004 771
- DE-C2- 4 128 766
- JP-A- H1 093 125
- JP-A- 2007 201 331
- US-A- 5 011 544
- US-A- 5 994 641
- US-A1- 2005 199 279
- US-A1- 2005 241 692
- US-A1- 2006 107 991
- Eugene Hecht, Optics, Addison Wesley Publishing Company, 2nd ed., 1987, ISBN 0-201-11611-1, pages 94-96
- B. S. Mitchell, An Introduction to Materials Engineering and Science:For Chemical and Materials Engineers, John Wiley & Sons, Inc., 2004, ISBN 0-471-43623-2, pages 900-902

## Description

The present invention relates to a solar cell module including solar cells connected to each other by wiring members.

A Solar cell directly converts clean and unlimitedly supplied sunlight into electricity. Thus, the solar cells are expected as a new energy source.

Generally, the output of a single solar cell is about several watts. For this reason, in order to use such a solar cell as a power source for a house, a building, or the like, a solar cell module in which solar cells are connected to each other to increase the output is used.

The solar cell module includes solar cells which are sealed with a sealing member between a light receiving surface side protection member and a back surface side protection member.

The solar cells are arrayed in an array direction and electrically connected to each other by wiring members. Specifically, each of the wiring members is connected to a light receiving surface of one solar cell and to a back surface of a different solar cell adjacent to the one solar cell.

Here, for the purpose of reducing optical loss caused by a surface of the wiring member, formation of asperities in the surface of the wiring member has been proposed (see specification of US Patent Application Publication No. 2007/0125415). Specifically, incident light toward the wiring member is reflected by the asperities formed in the surface of the wiring member, reflected once more by the interface between the light receiving surface side protection member and the atmosphere, and then guided to the solar cells.

In a manufacturing process of the solar cell module, the above-described wiring member is usually formed by cutting a long metal wire to a predetermined length, the metal wire having asperities formed entirely in one-side surface. However, a problem arises when such a wiring member is connected to the light receiving surface of the one solar cell and to the back surface of the other solar cell. That is, the adhesion between the back surface of the other solar cell and the wiring member is lowered because the asperities are formed in the one-side surface of the wiring member facing the back surface of the other solar cell.

In addition, in the manufacturing process of the solar cell, it is troublesome to form the asperities only in a portion of the wiring member that faces the light receiving surface side protection member, in other words, in the surface of a portion of the wiring member that is disposed on the light receiving surface of the one solar cell.

WO99/09601 discloses a solar cell assembly for focusing incident radiation on a solar cell. The assembly comprises a reflective member having first and second opposite surfaces. The first surface is transparent to allow incident radiation to pass into the reflective member. The second surface has a plurality of reflective portions positioned to receive the radiation and reflect and focus the radiation toward the first surface. The radiation strikes the first surface at an angle greater than a critical angle of the first surface and is reflected and focused back toward the second surface. The assembly further comprises a solar cell positioned at least proximate to the reflective member to receive the radiation reflected and focused from the first surface of the reflective member and generate electric current from the radiation.

US 2005/0016580 A1 discloses a solar battery module wherein a light diffusion section for diffusely reflecting a light or a light diffusion section of a white colour is arranged in an invalid region of each solar cell.

The present invention is made in view of the above-described circumstances. A preferred aim of the present invention is to provide a solar cell module having a reduced optical loss caused by a surface of a wiring member while maintaining excellent adhesion between the wiring member and a solar cell.

According to the present invention there is provided a solar cell module as specified in claim 1.

### IN THE DRAWINGS

Fig. 1 is a side view of a solar cell module 100 according to a first embodiment of the present invention.
Figs. 2A and 2B are plan views of solar cells 10 according to the first embodiment of the present invention.
Fig. 3 is an enlarged side view of a solar cell string 1 according to the first embodiment of the present invention.
Fig. 4 is a plan view of the solar cell string 1 according to the first embodiment of the present invention, the solar cell string 1 viewed from a light receiving surface side.
Fig. 5 is an enlarged side view of a solar cell string 1 according to a first non-claimed example.
Fig. 6 is a plan view of the solar cell string 1 according to the first non-claimed example, the solar cell string 1 viewed from a light receiving surface side.
Fig. 7 is an enlarged side view of a solar cell string according to a second non-claimed example.
Figs. 8A and 8B are enlarged side views of solar cell strings according to further non-claimed examples.

Next, an embodiment of the present invention will be described by using the drawings. In the following descriptions of the drawings, identical or similar constituents are denoted by identical or similar reference numerals. However, it is to be noted that the drawings are merely schematic and proportions of dimensions, for example, are different from actuality. Therefore, concrete dimensions, for example, should be determined in consideration of the following description. Moreover, dimensional relations and proportions may naturally be different among the drawings in some parts.

### [First Embodiment]

### (Configuration of solar cell module)

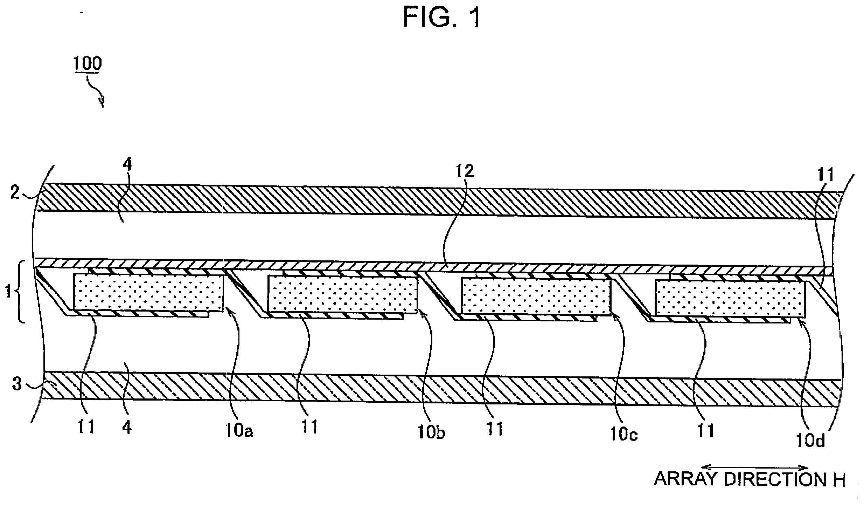

A schematic configuration of a solar cell module 100 according to a first embodiment of the present invention will be described with reference to Fig. 1. Fig. 1 is a side view of the solar cell module 100 according to the first embodiment.

The solar cell module 100 includes a solar cell string 1, a light receiving surface side protection member 2, a back surface side protection member 3, and a sealing member 4.

The solar cell string 1 is sealed between the light receiving surface side protection member 2 and the back surface side protection member 3 with the sealing member 4. The solar cell string 1 includes solar cells 10 (solar cells 10a to 10c), wiring members 11, and a reflecting plate 12.

The solar cells 10 are electrically connected to each other by the wiring members 11. The reflecting plate 12 is disposed between the light receiving surface side protection member 2 and the solar cells 10. Specifically, the reflecting plate 12 is disposed on the wiring members 11. The configuration of the solar cell string 1 will be described later in detail.

Each of the solar cells 10 has a light receiving surface that faces the light receiving surface side protection member 2, and a back surface that is provided on a side opposite to the light receiving surface and faces the back surface side protection member 3. The solar cells 10 are arrayed in an array direction H. The configuration of each of the solar cells 10 will be described later in detail.

The light receiving surface side protection member 2 is disposed on a light receiving surface side of each of the solar cells 10, and protects the front surface of the solar cell module 100. For the light receiving surface side protection member 2, a translucent and water-shielding glass, a translucent plastic, or the like may be used.

The back surface side protection member 3 is disposed on a back surface side of each of the solar cells 10, and protects the back surface of the solar cell module 100. For the back surface side protection member 3, a resin film made of polyethylene terephthalate (PET) or the like, or a stacked film having such a structure that a metal foil such as an Al foil or the like is sandwiched by resin films may be used, for example.

The sealing member 4 seals the solar cell string 1 between the light receiving surface side protection member 2 and the back surface side protection member 3. For the sealing member 4, a translucent resin such as EVA, EEA, PVB, silicone, urethane, acrylic, epoxy, or the like may be used.

In addition, an Al frame (unillustrated) may be attached to the periphery of the solar cell module 100 having the above-described configuration.

### (Configuration of solar cell)

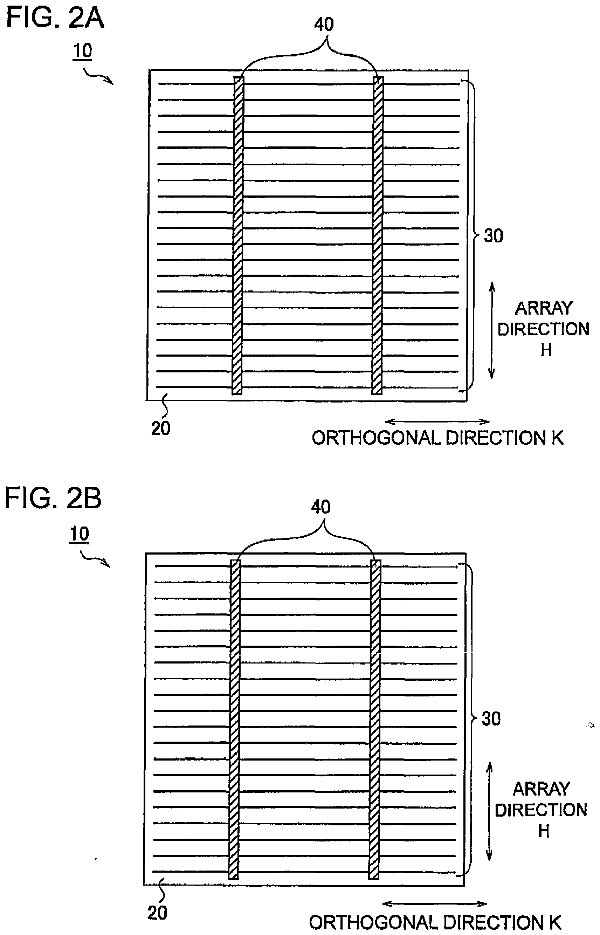

The configuration of the solar cell 10 according to the first embodiment will be described below with reference to the drawings. Fig. 2A is a plan view of the solar cell 10 viewed from the light receiving surface side. Fig. 2B is a plan view of the solar cell 10 viewed from the back surface side.

As shown in Figs. 2A and 2B, the solar cell 10 includes a photoelectric conversion part 20, thin line-shaped electrodes 30, and connecting electrodes 40. The thin line-shaped electrodes 30 and connecting electrodes 40 are formed in a comb shape similarly on both the light receiving surface and the back surface of the solar cell 10.

The photoelectric conversion part 20 generates photo-generated carriers by receiving light. The photo-generated carriers are holes and electrons generated when the photoelectric conversion part 20 absorbs solar light. The photoelectric conversion part 20 is provided inside with a semiconductor junction such as a pn junction, pin junction, or the like. The photoelectric conversion part 20 can be formed by using a general semiconductor material. Examples of such a semiconductor material include: a crystalline semiconductor material, such as a monocrystalline Si or a polycrystalline Si; a compound semiconductor material, such as GaAs or InP; and the like.

The thin line-shaped electrodes 30 are collecting electrodes collecting carriers from the photoelectric conversion part 20. Each of the thin line-shaped electrodes 30 is formed on the photoelectric conversion part 20 so as to extend in an orthogonal direction K approximately orthogonal to the array direction H. Each of the thin line-shaped electrodes 30 can be made of, for example, a resin conductive paste, a sintered conductive paste (i.e., ceramic paste), or the like. Note that the size and the number of the thin line-shaped electrodes 30 can be set as appropriate in consideration of the size and the properties of the photoelectric conversion part 20. For example, in a case where the photoelectric conversion part 20 has a size of approximately 100 mm square, approximately 50 thin line-shaped electrodes 30 can be formed. In addition, on the back surface of the solar cell 10, a collecting electrode covering the entire back surface may be formed instead of the thin line-shaped electrodes 30.

The connecting electrodes 40 are connected to the wiring members 11. The connecting electrodes 40 are formed on the photoelectric conversion part 20 so as to extend in the array direction H. The connecting electrodes 40 can be made of a resin conductive paste, a sintered conductive paste (ceramic paste), or the like. Note that the size and the number of the connecting electrodes 40 can be set as appropriate in consideration of the size and the properties of the photoelectric conversion part 20. For example, in a case where the photoelectric conversion part 20 has a size of approximately 100 mm square, two connecting electrodes 40 each having a width of approximately 1.5 mm can be formed.

### (Configuration of solar cell string)

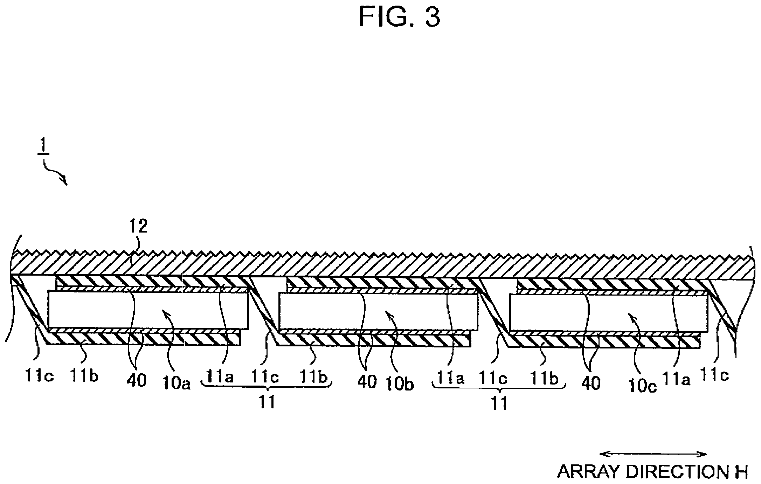

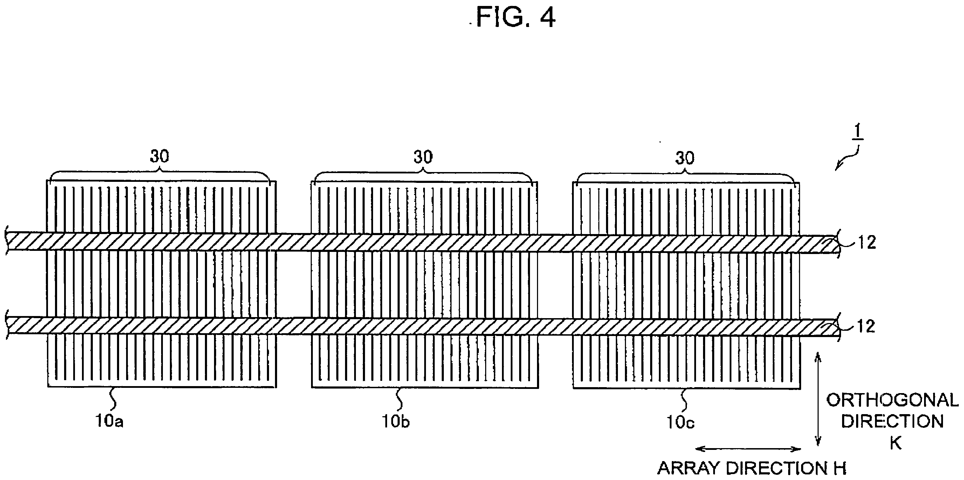

The configuration of the solar cell string 1 according to the first embodiment will be described below with reference to the drawings. Fig. 3 is an enlarged side view of the solar cell string 1. Fig. 4 is a plan view of the solar cell string 1 viewed from the light receiving surface side.

As shown in Fig. 3, each of the wiring members 11 electrically connects one solar cell 10 and a different solar cell 10 adjacent to the one solar cell 10. Specifically, the wiring members 11 extend in the array direction H and are connected to the connecting electrode 40 formed on the light receiving surface of the one solar cell 10 and to the connecting electrode 40 formed on the back surface of the different solar cell 10.

Specifically, each of the wiring members 11 has: a connecting portion 11a, a connecting portion 11b, and a communicating portion 11c. The connecting portion 11a is a portion of the wiring member 11 that is connected to the light receiving surface of the one solar cell 10. The connecting portion 11b is a portion of the wiring member 11 that is connected to the back surface of the different solar cell 10. The communicating portion 11c is a portion of the wiring member 11 that communicates with the connecting portion 11a and the connecting portion 11b.

Note that the light receiving surface of the solar cell 10 according to the present embodiment has one polarity whereas the back surface thereof has the other polarity. Thus, the one solar cell 10 and the different solar cell 10 are electrically connected to each other in series by the wiring members 11.

Each of the wiring members 11 is made of a low resistance element and a conductive material covering a surface of the low resistance element. For the low resistance element, a thin plate or a twisted wire made of copper, silver, gold, tin, nickel, aluminum, an alloy of any of these metals, or the like may be used. For the conductive material, lead-free solder plating, tin plating, or the like may be used.

Here, as shown in Fig. 3, the reflecting plate 12 is disposed over connecting portions 11a of each of the wiring members 11. Note that, the reflecting plate 12 is bonded to the connecting portions 11a by use of a resin adhesive or the like, although such bonding is not illustrated in the drawing. Thus, as shown in Fig. 4, the reflecting plate 12 is disposed over the solar cells 10 so as to extend in the array direction H, in a plan view seen from the light receiving surface side of the solar cell string 1.

The reflecting plate 12 is made of a conductive metal material. Here, a surface of the reflecting plate 12 that faces the connecting portions 11a provides electrical isolation. This structure suppresses occurrences of electrical short circuits between the solar cells 10. The surface of the reflecting plate 12 that faces the connecting portions 11a is subjected to an insulation process, or the reflecting plate 12 is bonded to the connecting portions 11a by use of an insulative adhesive so that the reflecting plate 12 can be electrically separated from the connecting portions 11a.

In addition, a surface (a top surface) of the reflecting plate 12 that faces the light receiving surface side protection member 2 has light reflectivity. Specifically, as shown in Fig. 3, multiple asperities are formed entirely in the top surface of the reflecting plate 12. This structure allows reflection (including scattering) of incident light toward each of the reflecting plate 12 (toward the wiring members 11) by the surfaces of the respective asperities. The light reflected by the surfaces of the respective asperities is reflected again at the interface between the light receiving surface side protection member 2 and the atmosphere, and then enters the photoelectric conversion part 20. Note that the base angles of each of the convex portions of the asperities formed in the top surface of the reflecting plate 12 is preferably determined so that light reflected by the surface of the convex portion would be totally reflected at the interface between the light receiving surface side protection member 2 and the atmosphere.

### (Advantageous effects)

The solar cell module 100 according to the first embodiment includes: the solar cells 10; the wiring members 11 electrically connecting the solar cells 10 to each other; and the reflecting plate 12 disposed between the light receiving surface side protection member 2 and the solar cells 10. The wiring members 11 have the connecting portions 11a connected to the light receiving surface of each of the solar cells 10. The reflecting plate 12 is disposed over the connecting portions 11a of the wiring members 11. The top surface of the reflecting plate 12 has light reflectivity.

In this way, incident light toward each of the wiring members 11 is reflected sequentially by the reflecting plate 12 and the light receiving surface side protection member 2, and then guided to the photoelectric conversion part 20. By making use of the light incident upon the surface of each of the wiring members 11, the photoelectric conversion efficiency of each of the solar cells 10 can be improved.

In addition, there is no need to perform a process to form asperities on the wiring members 11, or the like, thus preventing lowering the adhesion between each of the wiring members 11 and the corresponding solar cell 10 (the connecting electrode 40).

Moreover, the reflecting plate 12 can be disposed on the solar cells 10 with the resin adhesive interposed therebetween, the solar cells 10 connected to each other by the wiring members 11. Thus, the reflecting plate 12 can be easily attached in the manufacturing process of the solar cell module 100.

Furthermore, the surface of the reflecting plate 12 that faces the connecting portion 11a and the connecting portion 11b of the respective wiring members 11 has insulating properties, thereby suppressing occurrences of short circuits between the solar cells 10 even when the reflecting plate 12 is made of a conductive material. Specifically, the occurrences of short circuits between the solar cells 10 can be suppressed by performing an insulation process on the surface of the reflecting plate 12 that faces the connecting portions 11a, or by bonding the reflecting plate 12 and the connecting portions 11a together by use of an insulative adhesive.

### [First non-claimed example]

A first non-claimed example will be described below with reference to the drawings. Descriptions will be provided below mainly for the differences between the first embodiment described above and the first non-claimed example.

Specifically, in the first non-claimed example, the reflecting plate 12 has multiple conductive portions disposed respectively on connecting portions 11a of the wiring members 11, and multiple insulating portions each communicating with a pair of adjacent conductive portions.

### (Configuration of solar cell string)

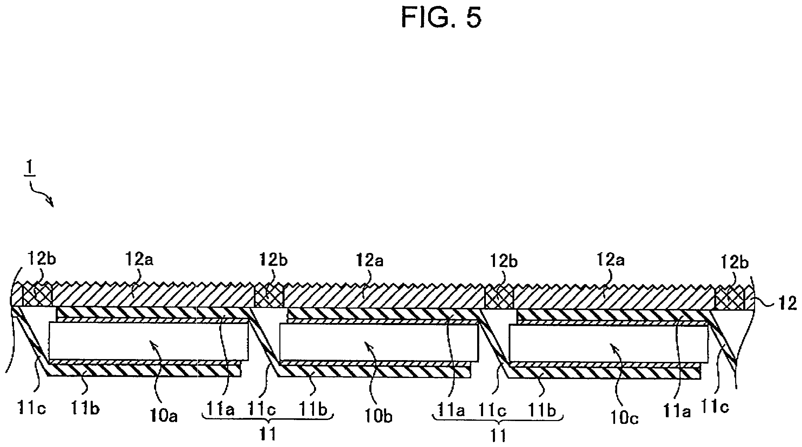

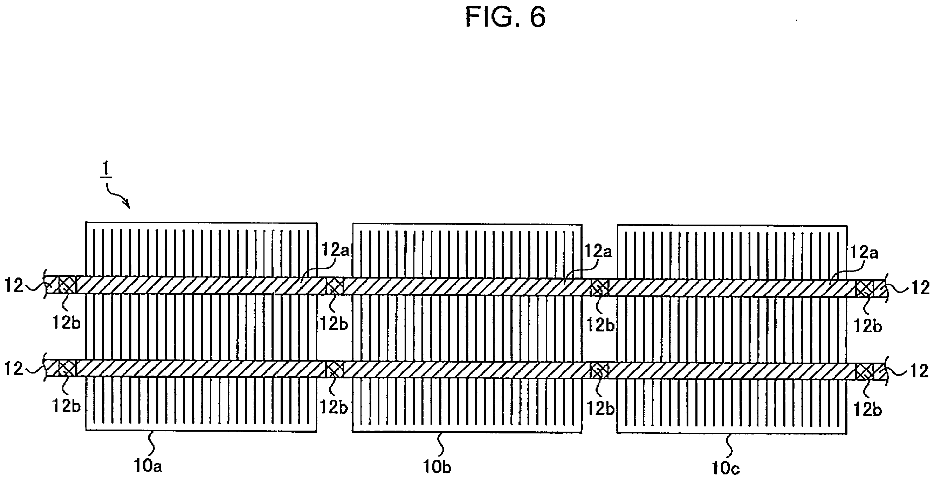

The configuration of a solar cell string 1 according to the first non-claimed example will be described below with reference to the drawings. Fig. 5 is an enlarged side view of the solar cell string 1. Fig. 6 is a plan view of the solar cell string 1 viewed from the light receiving surface side.

As shown in Fig. 5 and Fig. 6, the reflecting plate 12 has conductive portions 12a disposed respectively on connecting portions 11a of the wiring members 11, and insulating portions 12b communicating with a pair of adjacent conductive portions 12a.

Each of the conductive portions 12a is made of a conductive material such as metal. No insulation process is performed on the surfaces of the reflecting plate 12 according to this non-claimed example, and thus the conductive portions 12a and the respective connecting portions 11a are electrically connected to each other.

Each insulating portion 12b is made of a known insulating material, and electrically separates the pair of the adjacent conductive portions 12a. Note that the conductive portions 12a and the insulating portions 12b are formed integrally. In addition, a surface of the conductive portions 12a and the insulating portions 12b that face a light receiving surface side protection member 2 has light reflectivity.

### (Advantageous effects)

The reflecting plate 12 according to the first non-claimed example has the conductive portions 12a and the insulating portions 12b each communicating with the pair of the adjacent conductive portions 12a.

Accordingly, occurrences of short circuits between solar cells 10 can be suppressed without performing an insulation process on the surfaces of the reflecting plate 12 that face the connecting portions 11a of the wiring members 11.

In addition, the conductive portions 12a are electrically connected to the connecting portions 11a, and thus function as part of the wiring members 11, respectively. It is therefore possible to reduce the inner electrical resistance of the wiring members 11.

Moreover, since the conductive portions 12a and the insulating portions 12b are formed integrally, the reflecting plate 12 can be easily disposed in the manufacturing process of the solar cell module 100.

### [Second non-claimed example]

A second non-claimed example will be described below with reference to the drawings. Descriptions will be provided below mainly for the differences between the first embodiment described above and the second non-claimed example.

Specifically, in the second non-claimed example, the wiring members 11 are each connected to light receiving surfaces of a pair of adjacent solar cells 10, or connected to back surfaces of the solar cells 10.

### (Configuration of solar cell string)

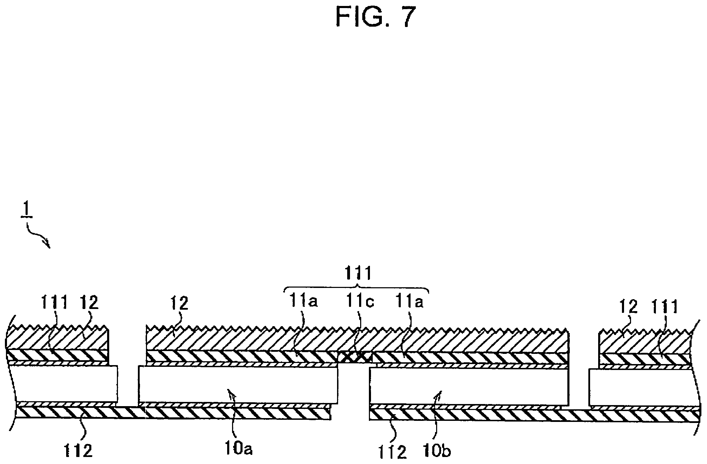

Fig. 7 is an enlarged side view of a solar cell string 1 according to the second non-claimed example. In the second non-claimed example, the wiring members 11 include: wiring members 111 each disposed on the light receiving surface sides of each of the solar cells 10; and wiring members 112 each disposed on the back surface sides of each of the solar cells 10.

As shown in Fig. 7, each of the wiring members 111 has: a pair of connecting portion 11a connected to a pair of the light receiving surface of the adjacent solar cells 10 (the solar cell 10a and the solar cell 10b); and a communicating portion 11c communicating with the pair of connecting portion 11a. Here, it should be noted that the pair of connecting portion 11a and the communicating portion 11c are integrally formed.

Each of the wiring members 112 is connected to a pair of the back surface of the adjacent solar cells 10.

Here, in the second non-claimed example, the polarity of the light receiving surface of the solar cell 10a is different from that of the light receiving surface of the solar cell 10b. The solar cell 10a is electrically connected to the solar cell 10b in series by one of the wiring members 111.

As shown in Fig. 7, each of reflecting plates 12 is disposed over the pair of the connecting portion 11a of the wiring members 111. In other words, each of the reflecting plates 12 according to the second non-claimed example is disposed on each of the wiring members 111 in an array direction. In addition, each of the reflecting plates 12 is made of a conductive material, such as metal, and electrically connected to each of the wiring members 111.

### (Other Embodiments)

Although the present invention has been described based on the above embodiment, it should not be understood that the statement and the drawings constituting part of this disclosure limit this invention. Various alternative embodiments, examples, and operation techniques become apparent to those skilled in the art from this disclosure.

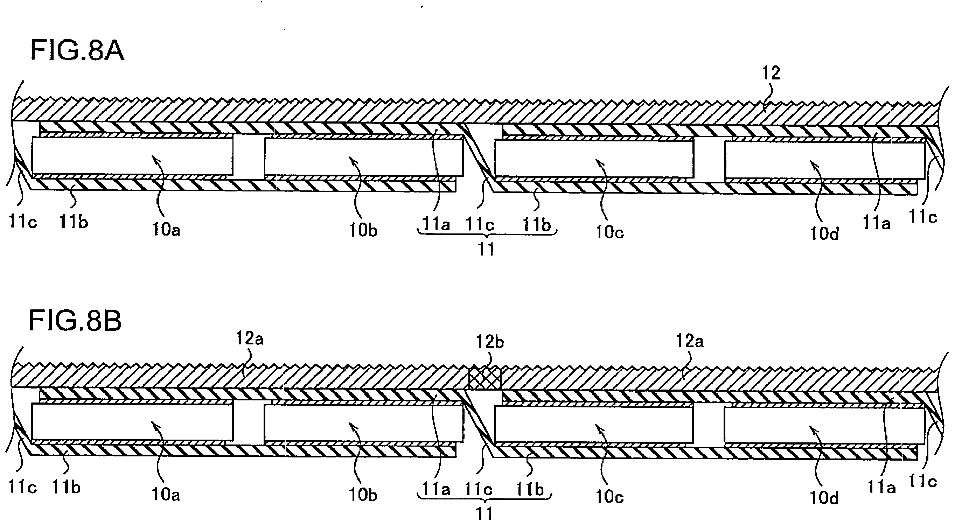

In further non-claimed examples, as shown in Figs. 8A and 8B, one wiring member 11 may connect the solar cell 10a and the solar cell 10b in parallel, connect the solar cell 10c and the solar cell 10d in parallel, and connect the parallel-connected solar cells 10a and 10b and the parallel-connected solar cells 10c and 10d in series.

To be more specific, as shown in Fig. 8A, each of the wiring members 11 has: a connecting portion 11a connected to the light receiving surfaces of the solar cell 10a and the solar cell 10b; a connecting portion 11b connected the back surfaces of the solar cell 10c and the solar cell 10d; and a communicating portion 11c communicating with the connecting portion 11a and the connecting portion 11b. The reflecting plate 12 is disposed over the connecting portions 11a of each of the wiring members 11.

In this case, it is preferable that a surface of the reflecting plate 12 that faces the connecting portions 11a should have insulating properties, but the configuration of the reflecting plate 12 is not limited to this. Specifically, as shown in Fig. 8B, the reflecting plate 12 may have conductive portions 12a disposed respectively on the connecting portions 11a, and insulating portions 12b each communicating with a pair of the adjacent conductive portions 12a.

The reflecting plate 12 is disposed on the connecting portions 11a in the above-described embodiment. However, if the solar cells 10 are bifacial-type solar cells, the reflecting plate 12 may be disposed over the connecting portions 11b as well. In other words, the reflecting plate 12 may also be disposed between the back surface side protection member 3 and the solar cells 10.

In addition, in the above-described embodiment, the thin line-shaped electrodes 30 and the connecting electrodes 40 are formed in the comb shape, but the configurations of the thin line-shaped electrodes 30 and the connecting electrodes 40 are not limited to this. For example, the wiring members 11 may be connected directly to the light receiving surfaces and the back surfaces of each of the solar cells 10 without forming the connecting electrodes 40 on the light receiving surfaces and the back surfaces.

In the above-described embodiment, the number of the solar cells 10 is not limited.

As described above, the present invention naturally includes various embodiments that are not described herein. Therefore, the technical scope of the present invention shall be determined solely by claimed elements according to the scope of claims reasonably understood from the above description and drawings.

## Claims

1. A solar cell module (100) comprising:
a plurality of solar cells (10, 10a-10d) including first to third solar cells (10a-10c) which are arrayed in an array direction (H) and which are sealed between a light receiving surface side protection member (2) and a back surface side protection member (3), each of which has a light receiving surface and a back surface provided on a side opposite to the light receiving surface, and each of which includes a photoelectric conversion part (20) and thin line-shaped electrodes (30) on the light receiving surface, wherein the thin line-shaped electrodes (30) are collecting electrodes collecting carriers from the photoelectric conversion part (20), and each of the thin line-shaped electrodes (30) is formed on the photoelectric conversion part (20) so as to extend in an orthogonal direction (K) to the array direction (H);
a first wiring member (11) connected to the light receiving surface of the first solar cell (10a) and to the back surface of the second solar cell (10b);
a second wiring member (11) connected to the light receiving surface of the second solar cell (10b) and to the back surface of the third solar cell (10c); and
a reflecting plate (12) disposed in the array direction (H) between the light receiving surface side protection member (2) and the first to third solar cells (10a-10c), and on the first wiring member (11) and the second wiring member (11);
wherein:
the first wiring member (11) has a first connecting portion (11a) disposed in the array direction (H) and connected to the light receiving surface of the first solar cell (10a),
the second wiring member (11) has a second connecting portion (11a) disposed in the array direction (H) and connected to the light receiving surface of the second solar cell (10b),
the reflecting plate (12) is disposed over the first and second connecting portions (11a),
multiple asperities having a light reflectivity are formed entirely in a surface of the reflecting plate (12) that faces the light receiving surface side protection member (2), so that incident light toward each of the first and second wiring members (11) is reflected sequentially by the reflecting plate (12) and the light receiving surface side protection member (2), and then guided to the photoelectric conversion part (20),
the reflecting plate (12) is made of a conductive metal material, and
a surface of the reflecting plate (12) that faces the first and second connecting portions (11a) is subjected to an insulation process, or the reflecting plate (12) is bonded to the first and second connecting portions (11a) by use of an insulative adhesive.

## Patentansprüche

1. Solarzellenmodul (100), umfassend:
eine Vielzahl von Solarzellen (10, 10a-10d), welche eine erste bis dritte Solarzelle (10a-10c) umfassen, die in eine Anordnungsrichtung (H) angeordnet sind und die zwischen einem Lichtaufnahme-Oberflächenseitenschutzelement (2) und einem Rückseiten-Oberflächenseitenschutzelement (3) abgedichtet sind und von denen jede eine Lichtaufnahme-Oberfläche und eine auf einer der Lichtaufnahme-Oberfläche entgegengesetzten Seite vorgesehene Rückseiten-Oberfläche aufweist, und von denen jede einen photoelektrischen Umwandlungsteil (20) und dünne, linienförmige Elektroden (30) auf der Lichtaufnahme-Oberfläche aufweist, wobei die dünnen, linienförmigen Elektroden (30) Sammelelektroden sind, die Träger vom photoelektrischen Umwandlungsteil (20) sammeln und wobei jede der dünnen, linienförmigen Elektroden (30) so auf dem photoelektrischen Umwandlungsteil (20) ausgebildet ist, dass sie sich in eine zur Anordnungsrichtung (H) orthogonalen Richtung (K) erstreckt;
ein erstes Verdrahtungselement (11), das mit der Lichtaufnahme-Oberfläche der ersten Solarzelle (10a) und der Rückseiten-Oberfläche der zweiten Solarzelle (10b) verbunden ist; und
ein zweites Verdrahtungselement (11), das mit der Lichtaufnahme-Oberfläche der zweiten Solarzelle (10b) und der Rückseiten-Oberfläche der dritten Solarzelle (10c) verbunden ist; und
eine Reflexionsplatte (12), die in der Anordnungsrichtung (H) zwischen dem Lichtaufnahme-Oberflächenseitenschutzelement (2) und der ersten bis dritten Solarzelle (10a-10c) und auf dem ersten Verdrahtungselement (11) und dem zweiten Verdrahtungselement (11) angeordnet ist;
wobei:
das erste Verdrahtungselement (11) einen ersten Verbindungsabschnitt (11a) aufweist, der in der Anordnungsrichtung (H) angeordnet und mit der Lichtaufnahme-Oberfläche der ersten Solarzelle (10a) verbunden ist;
das zweite Verdrahtungselement (11) einen zweiten Verbindungsabschnitt (11a) aufweist, der in der Anordnungsrichtung (H) angeordnet und mit der Lichtaufnahme-Oberfläche der zweiten Solarzelle (10b) verbunden ist,
die Reflexionsplatte (12) über dem ersten und dem zweiten Verbindungsabschnitt (11a) angeordnet ist, und
mehrere Unebenheiten, die ein Lichtreflexionsvermögen aufweisen, vollständig in einer Oberfläche der Reflexionsplatte (12) ausgebildet sind, die dem Lichtaufnahme-Oberflächenseitenschutzelement (2) zugewandt ist, sodass auf jedes aus dem ersten und zweiten Verdrahtungselement (11) einfallendes Licht nacheinander durch die Reflexionsplatte (12) und das Lichtaufnahme-Oberflächenseitenschutzelement (2) reflektiert und dann zum photoelektrischen Umwandlungsteil (20) geleitet wird,
die Reflexionsplatte (12) aus einem leitenden Metallmaterial besteht und
eine Oberfläche der Reflexionsplatte (12), die dem ersten und zweiten Verbindungsteil (11a) zugewandt ist, einem Isolierungsvorgang unterzogen wird oder die Reflexionsplatte (12) mit dem ersten und zweiten Verbindungsteil (11a) unter Verwendung eines isolierenden Klebers verbunden ist.

## Revendications

1. Module de cellules solaires (100) comprenant :
une pluralité de cellules solaires (10, 10a-10d) comprenant des première à troisième cellules solaires (10a-10c) qui sont disposées en réseau dans une direction de réseau (H) et qui sont scellées entre un élément de protection côté surface de réception de lumière (2) et un élément de protection côté surface arrière (3), et dont chacun présente une surface de réception de lumière et une surface arrière disposée sur un côté opposé à la surface de réception de lumière, et dont chacune comprend une partie de conversion photoélectrique (20) et des électrodes en forme de ligne mince (30) sur la surface de réception de lumière, dans lesquelles les électrodes en forme de ligne mince (30) sont des électrodes de collecte qui collectent des porteuses provenant de la partie de conversion photoélectrique (20), et chacune des électrodes en forme de ligne mince (30) est formée sur la partie de conversion photoélectrique (20) de manière à s'étendre dans une direction orthogonale (K) à la direction de réseau (H) ;
un premier élément de câblage (11) connecté à la surface de réception de lumière de la première cellule solaire (10a) et à la surface arrière de la deuxième cellule solaire (10b) ;
un second élément de câblage (11) connecté à la surface de réception de lumière de la deuxième cellule solaire (10b) et à la surface arrière de la troisième cellule solaire (10c) ; et
une plaque réfléchissante (12) est disposée dans la direction de réseau (H) entre l'élément de protection côté surface de réception de lumière (2) et les première à troisième cellules solaires (10a-10c), et sur le premier élément de câblage (11) et le second élément de câblage (11) ;
dans lequel :
le premier élément de câblage (11) présente une première partie de connexion (11a) disposée dans la direction de réseau (H) et connectée à la surface de réception de lumière de la première cellule solaire (10a),
le second élément de câblage (11) présente une seconde partie de connexion (11a) disposée dans la direction de réseau (H) et connectée à la surface de réception de lumière de la deuxième cellule solaire (10b),
la plaque réfléchissante (12) est disposée sur les première et seconde parties de connexion (11a),
de multiples aspérités présentant une réflectivité lumineuse sont formées entièrement dans une surface de la plaque réfléchissante (12) qui fait face à l'élément de protection côté surface de réception de lumière (2), de telle sorte que de la lumière incidente vers chacun des premier et second éléments de câblage (11) est réfléchie séquentiellement par la plaque réfléchissante (12) et l'élément de protection côté surface de réception de lumière (2), puis guidée vers la partie de conversion photoélectrique (20),
la plaque réfléchissante (12) est réalisée en un matériau métallique conducteur, et
une surface de la plaque réfléchissante (12) qui fait face aux première et seconde parties de connexion (11a) est soumise à un processus d'isolation, ou la plaque réfléchissante (12) est liée aux première et seconde parties de connexion (11a) à l'aide d'un adhésif isolant.
